# EUROPÄISCHE PATENTSCHRIFT

(11) **EP 1 494 355 B1**
(45) Veröffentlichungstag und Bekanntmachung des Hinweises auf die Patenterteilung: **19.05.2010**
(21) Anmeldenummer: 04007340.5
(22) Anmeldetag: 26.03.2004
(51) Int. Cl.: H03K 17/687, H03K 17/16

(54) **Elektronischer Schalter**
Electronic switch
Commutateur électronique

(30) Priorität: 30.06.2003 DE 10329394; 14.07.2003 DE 10331804
(43) Veröffentlichungstag der Anmeldung: 05.01.2005
(60) Teilanmeldung: 05017512.4
(73) Patentinhaber: Rohde & Schwarz GmbH & Co. KG, 81671 München (DE)
(72) Erfinder: Nöst, Peter, 81539 München (DE)
(74) Vertreter: Körfer, Thomas

(56) Entgegenhaltungen:
- EP-A- 0 415 081
- FR-A- 2 612 022
- US-A- 3 325 654
- US-A- 3 524 996
- US-A- 4 316 101
- US-A- 4 595 847
- US-A- 4 808 859
- US-A- 5 461 265
- US-A- 5 602 505
- US-A- 5 818 283
- US-B1- 6 201 455
- PATENT ABSTRACTS OF JAPAN Bd. 1998, Nr. 08, 30. Juni 1998 (1998-06-30) -& JP 10 084267 A (HITACHI LTD), 31. März 1998 (1998-03-31)
- MIYATSUJI K ET AL: "A GAAS HIGH POWER RF SINGLE POLE DUAL THROW SWITCH IC FOR DIGITAL MOBILE COMMUNICATION SYSTEM" IEEE JOURNAL OF SOLID-STATE CIRCUITS, IEEE INC. NEW YORK, US, Bd. 30, Nr. 9, 1. September 1995 (1995-09-01), Seiten 979-983, XP000526204 ISSN: 0018-9200
- YITZAK COHEN ET AL: "IMPROVED BIASING FOR A POWER MOSFET ACTING AS A SWITCH" MOTOROLA TECHNICAL DEVELOPMENTS, MOTOROLA INC. SCHAUMBURG, ILLINOIS, US, Bd. 14, 1. Dezember 1991 (1991-12-01), Seite 40, XP000276146 ISSN: 0887-5286

## Beschreibung

Die Erfindung betrifft einen elektronischen Schalter laut Oberbegriff des Anspruchs 1.

Elektronische Schalter werden in der Hochfrequenztechnik beispielsweise zum Schalten von Dämpfungsgliedern in Eichleitungen und dergleichen benutzt. Das zu schaltende Hochfrequenzsignal wird dabei im leitenden Zustand des Feldeffekt-Schaltransistors über den Source-Drain-Kanal dem Verbraucher zugeführt. Die Steuerung des Ein-Aus-Zustandes des Schalters erfolgt über ein dem Gate-Anschluß des Feldeffekt-Schalttransistors zugeführtes Steuersignal.

Im Frequenzbereich über etwa 100 MHz besitzen solche elektronischen Schalter ausgezeichnete Linearität, bei niedrigeren Frequenzen unter etwa 100 MHz wird die Linearität jedoch sehr schlecht und das zu schaltende Signal wird stark verzerrt. Dies ist darauf zurückzuführen, daß bei geschalteten Signalen mit niedrigen Frequenzen und Amplituden größer gleich der Abschnürspannung (Pinch-Off-Spannung) des Schalttransistors der Spannungsabfall zwischen Gate und Soruce bzw. Gate und Drain während der positiven Halbwelle des zu schaltenden Signals betragsmäßig die Pinch-Off-Spannung überschreitet. Der Schalttransistor wechselt so aufgrund des Signalverlaufes des zu schaltenden Signals in den AUS-Zustand.

Um dieses Niederfrequenz-Großsignal-Verhalten zu verbessern ist es aus der US 5,107,152 bekannt, einen relativ großen Gate-Vorwiderstand bzw. eine hochohmige Diode in Reihe dazu vorzusehen. Durch diese bekannten Maßnahmen werden jedoch die Umschaltzeiten des Schalters unnötig verlängert.

Es ist daher die Aufgabe der Erfindung, einen elektronischen Schalter dieser Art bezüglich seines Niederfrequenz-Großsignal-Verhaltens zu verbessern, ohne dabei die sonstigen Eigenschaften des Schalters zu beeinträchtigen.

Diese Aufgabe wird ausgehend von einem elektronischen Schalter laut Oberbegriff des Anspruchs 1 durch die kennzeichnenden Merkmale des Anspruchs 1 gelöst. Vorteilhafte Weiterbildungen ergeben sich aus dem Unteranspruch.

Bei einem Gallium-Arsenid-Halbleiter-Feldeffekt-Schalttransistor, bei dem die Gate-Spannung zum Schalten zwischen leitendem und nicht leitendem Zustand in einer Gleichrichterschaltung erzeugt wird, ist es an sich bekannt, einen Teil der zu schaltenden Signalspannung über einen Koppelkondensator vom Drain-Anschluss zu dieser Gleichrichterschaltung zuzuführen (PATENT ABSTRACTS OF JAPAN Bd. 1998, Nr. 08, 30. Juni 1998 (1998-06-30) &JP 10 084267 A (HITACHI LTD), 31. März 1998 (1998-03-31).

Bei einem elektronischen Hochspannungs-Schalter mit zwei MOS Deplation-Feldeffekt-Transistor im Signalpfad ist es auch schon bekannt, zur Erhöhung der Spannungsfestigkeit des Schalters zwischen dem Source-Anschluss und dem Gate-Anschluss, zwischen denen parasitäre Kapazitäten wirken, einen zusätzlichen Widerstand anzuordnen (US-A4, 595, 847).

Mit diesen beiden jeweils zu anderen Zwecken vorgesehenen bekannten Schaltungen könnte das erfindungsgemäße Problem nicht gelöst werden. Erst durch die erfindungsgemäße Schaltung wird gewährleistet, dass auch bei tiefen Frequenzen im kHz-Bereich das Gate-Potential am Feldeffekt-Schalttransistor gleich groß und phasengleich ist bzw. durch den Gleichrichtereffekt sogar größer als das Potential am Source- bzw. Drain-Anschluss ist und daher ein solcher elektronischer Schalter auch bei tiefen Frequenzen lineares Übertragungsverhalten besitzt und Signalverzerrungen vermieden werden. Bei Gleichspannungs-(DC)-Kopplung ist sogar ein lineares Verhalten bei tiefen Frequenzen bis hin zu Gleichspannung (DC) möglich.

Die Erfindung wird im Folgenden an Ausführungsbeispielen näher erläutert. In der Zeichnung zeigen:
- Fig. 1: ein Beispiel eines nicht erfindungsgemäßen elektronischen Schalters;
- Fig. 2: ein Ausführungsbeispiel des erfindungsgemäßen elektronischen Schalters;
- Fig. 3: die Signalspannungen V_{G}, V_{D}, V_{S} und V_{O} aus Fig. 1 als Funktion der Zeit t;
- Fig. 4: die Signalspannungen V_{G}, V_{D}, V_{S} und V_{O} aus Fig. 2 als Funktion der Zeit t und
- Fig. 5: die Signalspannungen V_{G}, V_{D}, V_{S} und V_{O} bei einem elektronischen Schalter ohne die erfindungsgemäßen Maßnahmen als Funktion der Zeit t.

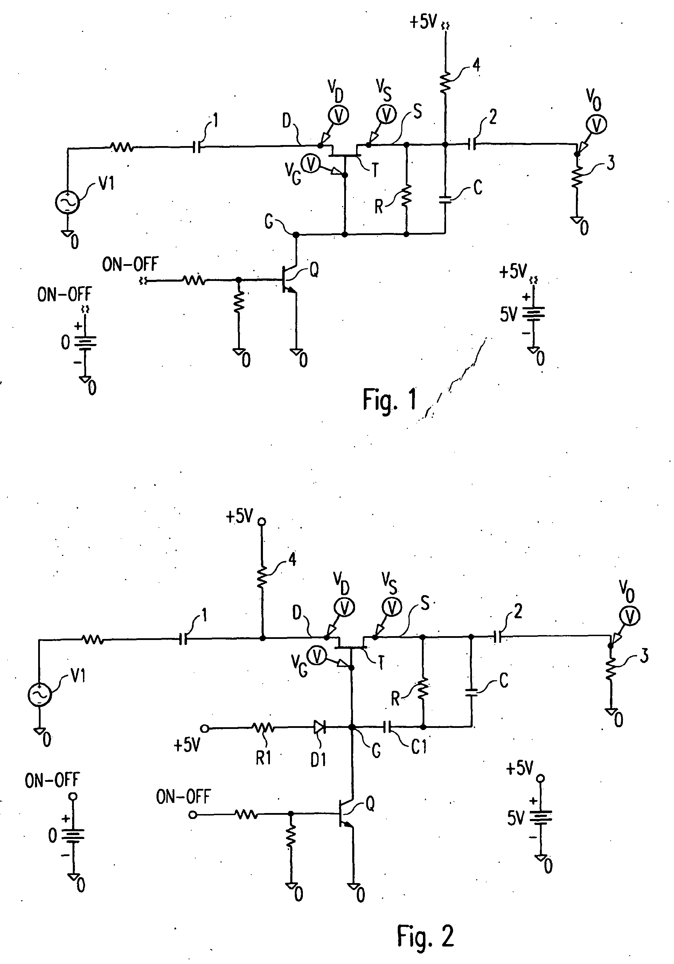

Fig. 1 zeigt ein nicht erfindungsgemäßes Beispiel zum Besseren Verständnis der Erfindung. Das zu schaltende Hochfrequenzsignal V1 wird über einen Koppelkondensator 1 dem Drain-Anschluß D des Feldeffekt-Schalttransistors T zugeführt, beispielsweise einen Gallium-Arsenid-Halbleiter-Feldeffekttransistor (GaAsMESFET). Der Source-Anschluß S des Schalttransistors T ist über einen Koppelkondensator 2 mit dem Verbraucher 3 verbunden. Das Gleichspannungspotential für den Transistor T wird über einen Widerstand 4 zugeführt, im gezeigten Ausführungsbeispiel aus einer +5V-Quelle bei einem Bezugspotential der Schaltung von 0 V. Die Steuerung des Transistors T in den leitenden (ON) bzw. sperrenden (OFF) Zustand erfolgt über ein am Gate-Anschluß G zugeführtes Steuersignal. Dieses Steuersignal besteht im einfachsten Fall aus zwei verschiedenen Gleichspannungswerten, die wechselweise dem Gate-Anschluß G zugeführt werden. Im gezeigten Ausführungsbeispiel wird durch Anlegen einer Steuerspannung von 0 V der Transistor T durchgeschaltet (ON), bei Anlegen einer Spannung von +5 V dagegen abgeschaltet (gesperrt, OFF).

Gemäß dem Beispiel nach Fig.1 ist zwischen Source-Anschluß S und Gate-Anschluß G die Parallelschaltung eines ohmschen Widerstandes R und eines Kondensators C angeordnet. Widerstand R und Kondensator C sind so dimensioniert, daß die Spannung am Gate-Anschluß G im durchgeschalteten Zustand amplitudengleich und phasengleich mit der Spannung am Source-Anschluß S ist. Die Dimensionierung hängt von der Art des verwendeten Feldeffekt-Schalttransistors sowie der Art der Zuleitungen zum Schalttransistor ab. Sie muß für den jeweiligen Transistortyp für niedrige Frequenzen jeweils so berechnet werden, daß die gewünschte Phasengleichheit an allen Anschlüssen des Transistors gewährleistet ist und damit auch bei tiefen Frequenzen die Spannung an den drei Anschlüssen des Schalttransistors jeweils gleich groß und in Phase ist, wie dies in Fig. 1 durch die Spannungsangaben V_{G} für die Gate-Spannung und V_{D} für die Drain-Spannung sowie V_{S} für die Source-Spannung angedeutet ist. V_{O} bezeichnet die Ausgangsspannung am Verbraucher 3.

Diese Mitführung des Gate-Potentials mit dem Signal-Potential kann auch vom Drain-Potential des Schalttransistors T abgeleitet werden, indem der Widerstand R mit parallel geschaltetem Kondensator C zwischen Drain-Anschluß D und Gate-Anschluß G angeordnet wird.

Fig. 2 zeigt ein erfindungsgemäßes Ausführungsbeispiel. Am Gate-Anschluß G ist mit ihrer Kathode eine Diode D1 angeschlossen, deren Anode über einen Widerstand R1 mit dem Gleichspannungspotential des Schalttransistors T, im Beispiel +5 V, vorgespannt ist. Durch diese Diode D1 werden im ON-Zustand die über die Source-Gate-Streukapazität bzw. die Drain-Gate-Streukapazität des Schalttransistors T oder durch eine zusätzliche Kapazität (siehe C1 Fig. 2) zum Gate gekoppelten Wechselspannungs-Signalanteile gleichgerichtet und hierdurch die Gate-Spannung geringfügig höher als die Source- bzw. Drain-Spannung. Dadurch wird das eingangs geschilderte Niederfrequenz-Großsignal-Verhalten verbessert.

Dieser Effekt wird noch dadurch verbessert, daß zusätzlich zur Diode D1 zwischen Source S oder Drain D und Gate G eine Reihenschaltung eines Widerstandes R und eines Trennkondensators C1 angeordnet wird.

Zur Verringerung einer etwaigen Phasenverschiebung zwischen Source- und Gatespannung wird zusätzlich zur Reihenschaltung R-C1 eine Kapazität C parallel zu R angebracht werden. Im Ausführungsbeispiel ist das Gleichspannungs-Potential des Schalttransistors T +5 V. In Anwendungsfällen, in denen das Gleichspannungspotential 0 V ist, wird die Diode D1 natürlich entsprechend mit 0 V vorgespannt. Selbstverständlich ist diese Art der Gate-Spannungserhöhung mittels einer zusätzlichen Diode auch in den Fällen anwendbar, in denen die Hochfrequenz-Signalzufuhr über die Parallelschaltung des Widerstandes mit dem Kondensator nicht vom Source-Anschluß sondern vom Drain-Anschluß erfolgt.

In dem Ausführungsbeispiel nach Fig. 2 erfolgt die Zuführung des Steuersignals zum Gate-Anschluß G über einen in Reihe zwischen Gate-Anschluß G und Bezugspotential geschalteten Transistor Q, der als bipolarer Transistor oder Feldeffekt-Transistor ausgebildet ist und eine verglichen mit den parasitären Kapazitäten zwischen Drain-Gate bzw. Source-Gate des Schalttransistors T geringe Kollektor-Emitter-Kapazität bzw. beim Feldeffekt-Transistor geringe Source-Drain-Kapazität besitzt.

Im ON-Zustand des Schalttransistors T (ON-Steuerspannung = 0 V) ist der Transistor Q hochohmig und die über den Widerstand R und den Kondensator C zum Gate-Anschluß geführte Mitführspannung kann am Gate voll wirksam werden. Im gesperrten Zustand (OFF-Steuerspannung = 5 V) ist der Transistor Q sehr niederohmig und das Gate-Potential des Schalttransistors T wird annähernd 0 V. Das durch den Spannungsteiler 4/R bestimmte Drain-Potential des Schalttransistors wird in etwa 5 V. Somit sperrt der Schalttransistor und es kann kein Hochfrequenzsignal V1 zum Verbraucher 3 gelangen.

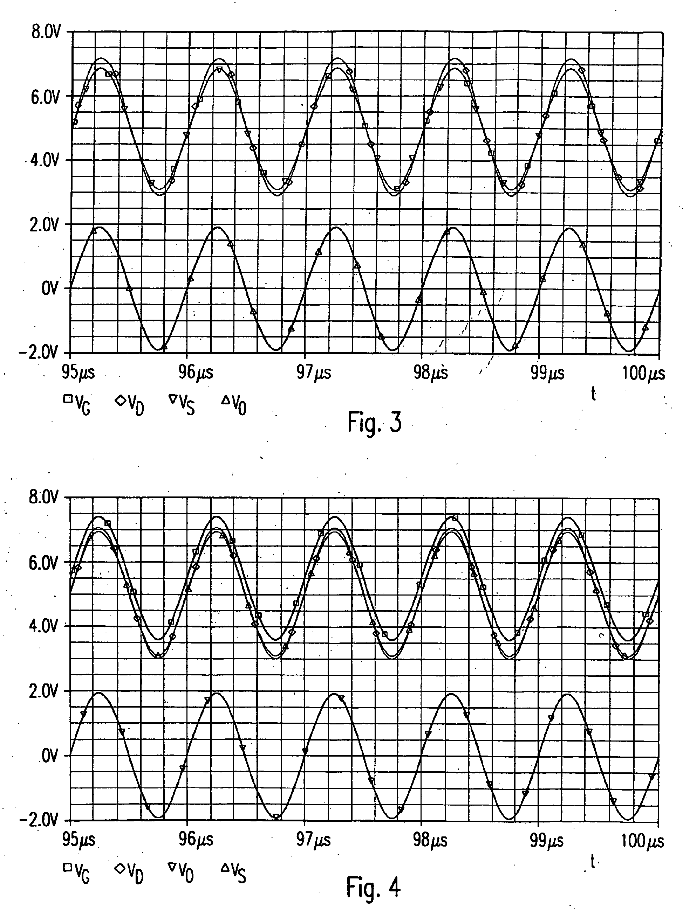

Fig. 3 zeigt zum besseren Verständnis der Erfindung die Gate-Spannung V_{G}, die Drain-Spannung V_{D}, die Source-Spannung V_{S} und die Ausgangsspannung V_{O} des in Fig. 1 dargestellten Beispiels als Funktion der Zeit t.

Weiterhin zeigt Fig. 4 die Gate-Spannung V_{G}, die Drain-Spannung V_{D}, die Source-Spannung V_{S} und die Ausgangsspannung V_{O} für das Ausführungsbeispiel der Fig. 2 als Funktion der Zeit t.

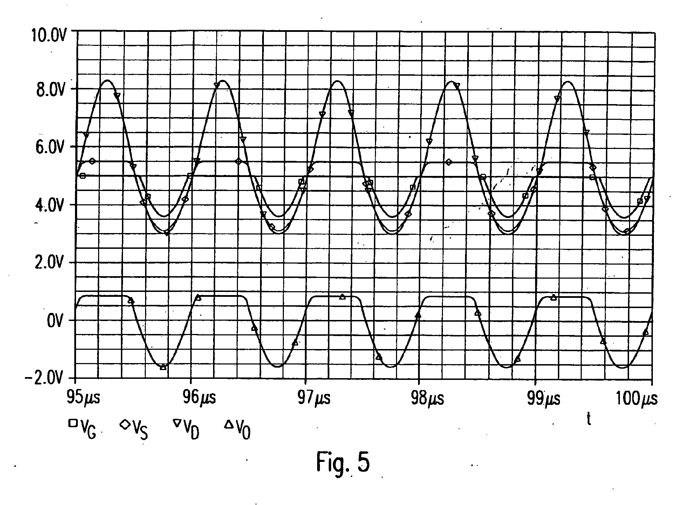

Zum Vergleich zeigt die Fig. 5 die Gate-Spannung V_{G}, die Drain-Spannung V_{D}, die Source-Spannung V_{S} und die Ausgangsspannung V_{O} für eine Ausführung ohne die erfindungsgemäßen Maßnahmen als Funktion der Zeit t.

Deutlich erkennbar ist, daß durch die erfindungsgemäßen Maßnahmen für tiefere Frequenzen eine erhebliche Linearisierung geschaffen wird.

## Patentansprüche

1. Elektronischer Schalter mit einem Metall-Halbleiter-Feldeffekt-Schalttransistor (T), an dessen Drain-Anschluss (D) ein zu schaltendes Signal (V1), an dessen Source-Anschluss (S) das geschaltete Signal und an dessen Gate-Anschluss (G) ein den Schalttransistor (T) zwischen leitendem und nicht-leitendem Zustand steuerndes Steuersignal anliegt,
**dadurch gekennzeichnet,**
**dass** zwischen Drain- oder Source-Anschluss (D oder S) und dem Gate-Anschluss (G) ein erster Widerstand (R) mit parallel dazu angeordnetem ersten Kondensator (C) geschaltet ist und der erste Widerstand (R) und der erste Kondensator (C) so dimensioniert sind, dass auch bei einer niederen Frequenz unterhalb von 100 MHz die Gate-Spannung (V_{G}) phasengleich mit der Spannung (V_{D} bzw. V_{S}) des Drain- bzw. Source-Anschlusses ist,
**dass** am Gate-Anschluss (G) eine vorgespannte Diode (D1) angeschlossen ist und zwar mit ihrem ersten Pol (Kathode) am Gate-Anschluss (G) und mit ihrem anderen Pol (Anode) über einen zweiten Widerstand (R1) an einem Gleichspannungspotential (z. B. +5V), das auch dem Schalttransistor (T) über einen dritten Widerstand (4) zugeführt ist und dass zwischen Drain- oder Source-Anschluss (D oder S) und dem Gate-Anschluss (G) eine Serienschaltung eines zweiten Kondensators (C1) mit dem ersten Widerstand (R) geschaltet ist,

2. Elektronischer Schalter nach Anspruch 1,
**dadurch gekennzeichnet,**
**dass** das Steuersignal über einen Bipolar- oder Feldeffekt-Transistor (Q) dem Gate-Anschluss (G) zugeführt ist, der eine verglichen mit dem parasitären Kapazitäten des Schalttransistors (T) kleine Kollektor-Emitter- bzw. Source-Drain-Kapazität aufweist.

## Claims

1. Electronic switch with a metallic-semiconductor-field-effect switching transistor (T), to the drain terminal (D) of which a signal (V1) is connected, to the source terminal (S) of which the switched signal is connected, and to the gate terminal (G) of which a control signal controlling the switching transistor (T) between a conductive and nonconductive condition is connected,
**characterised in that**,
between the drain or source terminal (D or S) and the gate terminal (G), a first resistor (R) with a first capacitor (C) arranged in parallel to the latter is connected, and the first resistor (R) and the first capacitor (C) are dimensioned in such a manner that even with a low frequency below 100 MHz, the gate voltage (V_{G}) is in phase with the voltage (V_{D} or respectively V_{S}) of the drain or respectively source terminal,
that, at the gate terminal (G), a biased diode (D1) is connected and, in fact, with its first pole (cathode) to the gate terminal (G) and with its other pole (anode), via a second resistor (R1), to a direct voltage potential (for example, +5V), which is also supplied to the switching transistor (T) via a third resistor (4) and
that, between the drain or source terminal (D or S) and the gate terminal (G), a series circuit of a second capacitor (C1) is connected with the first resistor (R).

2. The electronic switch according to claim 1,
**characterised in that**
the control signal is supplied via a bipolar or field-effect transistor (Q) to the gate terminal (G), which provides a small collector-emitter capacitance or respectively source-drain capacitance by comparison with the parasitic capacitances of the switching transistor (T).

## Revendications

1. Commutateur électronique comportant un transistor de commutation à effet de champ métal-semiconducteur (T), au drain (D) duquel se trouve un signal à commuter (V1), à la source (S) duquel se trouve le signal commuté et à la grille (G) duquel se trouve un signal de commande commandant le transistor de commutation (T) entre un état conducteur et un état non conducteur,
**caractérisé en ce que**
entre le drain ou la source (D ou S) et la grille (G) est reliée une première résistance (R) à un premier condensateur (C) monté en parallèle et la première résistance (R) et le premier condensateur (C) sont dimensionnés de sorte que la tension de grille (V_{G}) est de même phase que la tension (V_{D} ou V_{S}) du drain ou de la source dans le cas d'une fréquence faible inférieure à 100 MHz,
**en ce qu'**une diode polarisée (D1) est reliée à la grille (G), et avec son premier pôle (cathode) à la grille (G) et avec son autre pôle (anode) par l'intermédiaire d'une seconde résistance (R1) à un potentiel électrique continu (par exemple +5V), qui est délivré également au transistor de commutation (T) par l'intermédiaire d'une troisième résistance (4) et
**en ce qu'**un circuit série d'un second condensateur (C1) est monté avec la première résistance (R) entre le drain ou la source (D ou S) et la grille (G).

2. Commutateur électronique selon la revendication 1,
**caractérisé en ce que**
le signal de commande est délivré par l'intermédiaire d'un transistor bipolaire ou à effet de champ (Q) à la grille (G), qui présente une petite capacité collecteur-émetteur ou source-drain par rapport à la capacité parasite du transistor de commutation (T).
